# EUROPEAN PATENT SPECIFICATION

(11) **EP 0 295 135 B1**
(45) Date of publication and mention of the grant of the patent: **10.03.1993**
(21) Application number: 88305344.9
(22) Date of filing: 10.06.1988
(51) Int. Cl.: H01L 21/00, H01L 21/308, H01L 23/52

(54) **Forming tungsten structures**
Herstellen von Wolframstrukturen
Formation de structures en tungstène

(30) Priority: 12.06.1987 US 62261
(43) Date of publication of application: 14.12.1988
(73) Proprietor: Hewlett-Packard Company, Palo Alto, California 94304 (US)
(72) Inventor: Beatty, Christopher C., Ft. Collins Colorado 80525 (US)
(74) Representative: Williams, John Francis

(56) References cited:
- US-A- 4 289 834
- IBM TECHNICAL DISCLOSURE BULLETIN, vol. 22, no. 10, March 1980, pages 4516-4517, New York, US; J.E. HITCHNER et al.: "Chromium as an rie etch barrier"
- RESEARCH DISCLOSURE, no. 262, February 1986, page 112, disclosure no. 26261; "Etching mask for ceramic substrate"
- SOLID STATE TECHNOLOGY, vol. 23, no. 12, December 1980, pages 79-82; N.E. MILLER et al.: "Hot-wall CVD tungsten for VLSI"
- VLSI Technology, International Student Edition, Ed. S.M. Sze, McGraw-Hill 1983, pp. 360-361.

## Description

### Background of the Invention

The present invention pertains generally to semiconductor fabrication and more specifically to multilevel integrated circuit metallization processes and devices.

The formation of conductors and other structures in a semiconductor using multilevel metallization processes typically employ aluminum that is deposited using conventional techniques such as sputtering. Although aluminum is simple and easy to work with in these processes, it has certain disadvantages when employed in a semiconductor device.

Aluminum is particularly susceptible to electromigration problems. As current passes through aluminum structures formed in a semiconductor, the atoms of the aluminum tend to migrate because of the low bonding strengths between the atoms. This is also reflected in the low melting temperature of aluminum. In very small structures in the semiconductor, e.g., one micrometre wide conductors, the migration of the aluminum atoms in response to the flow of current can cause an open circuit. Due to the effect of electromigration, strict limits must be imposed as to the minimum size of structures formed from aluminum in a semiconductor circuit.

Aluminum also tends to corrode quite easily in a semiconductor circuit. Typically, the pattern of structures is formed through a process of etching using a chlorine based etcher. If any of the chlorine is left behind after the etching process is completed, it acts as a catalyst to corrode the aluminum layer. For example, if any aluminum chloride remains it will react with water to form aluminum oxide, aluminum hydroxide and hydrochloric acid, which in turn combines with the aluminum in the circuit to form aluminum chloride, such that the process continues in a progressive fashion to corrode the aluminum in the circuit. Because of the complex structures that exist in most semiconductor circuits, it is extremely difficult to remove all of the aluminum chloride to prevent deterioration of the circuit due to corrosion of the aluminum.

The methods of depositing aluminum using physical vapor deposition techniques such as sputtering and evaporation can also cause problems in the resulting semiconductor device. For example, shadowing and geometric effects occur when aluminum is deposited using conventional physical vapor deposition techniques. In other words, deposition of aluminum by the process of sputtering over a structured topology having, e.g., steps and deep holes on the surface of the semiconductor, will many times not provide a uniform covering of the uneven surface topology. More specifically, physical vapor deposition techniques will not provide a uniform deposition of aluminum atoms on the back side of tall structures and aluminum atoms will not be deposited in holes such that a uniform surface coverage is provided. When the surface is etched, discontinuities are likely to occur because of the non-uniform coverage.

Another problem that occurs because of the non-planarity of the substrate is that stringers, i.e., unetched portions of thick layers of the aluminum surrounding steps on the semiconductor surface, are not eliminated during the etching process so that a short circuit is produced between adjacent aluminum structures. In the process of etching the aluminum, the etching process is allowed to continue to fully etch the flat portions of the aluminum which are inherently much thinner than the thicker portions that occur around steps on the semiconductor. If the stringer exists between two adjacent conductors, for example, a short circuit will result. To eliminate stringers, overetching is employed to ensure that all the aluminum is removed in the etching areas. However, the process of overetching, in this manner, to remove stringers, will many times result in undercutting and other degradation of the aluminum structure, as well as damage to other surfaces, such as semiconductor surfaces on the semiconductor chip. The undercutting process, i.e., the removal of aluminum at the interface of the aluminum and the surface in which it is deposited, can also cause discontinuities and reduce the width of the aluminum structure to further intensify electromigration problems and increase line resistance.

One solution to this problem is proposed in the IBM Technical Disclosure Bulletin vol. 22 No: 10 March 1980, which discloses a method of forming metallic structures a semiconductor device surface comprising the steps of forming a chromium layer over at least part of the surface, forming a further metallic layer on the chromium layer, forming a patterned protective layer over the further metallic layer, and etching the further metallic layer through the protective layer to form metallic structures on the chromium layer.

The chromium layer acts as an etch stop to protect the semiconductor device surface whilst etching the further metallic layer. The horizontal geometry of the metallic structures is governed by a photoresist overlay. However, etching of the photoresist also takes place as the further metallic layer is etched. This reduces the definition of the metallic structures and limits the aspect ratio attainable.

Additionally, to ensure conductivity for vias, i.e. connections between two vertically disposed metal conductors in a semiconductor circuit, and between contacts, i.e., connection between a vertically disposed metal layer and a silicon layer, dogbones are typically employed. A dogbone comprises a widened portion of the circuit to ensure full horizontal registration between the layers that are designed to be conductively connected. When working in the one micron region, full horizontal registration between vertically disposed layers does not always occur. In many cases, a trench or deep hole will form at the contact or via adjacent to the underlayer to which the connection is to be made. Since sputtered aluminum will not penetrate and deposit in deep holes or trenches, proper contact is not made unless there is enclosure of the via. Hence, the widened portions, or dogbones, are provided to ensure that full horizontal registration occurs and adequate contact is made. The disadvantage of using dogbones is that they limit the density of the circuit since the electromigration problems of aluminum inherently limit the minimum size of the aluminum structures in the circuit. In other words, the minimum width of the aluminum structures is increased since widened portions must be provided to ensure horizontal registration and full conductive contact at vias and contacts.

According to the present invention there is provided a method of forming metallic structures on a semiconductor device surface comprising the steps of forming a chromium layer over at least part of the surface, forming a further metallic layer on the chromium layer, forming a patterned protective layer over the further metallic layer, and etching the further metallic layer through the protective layer to form metallic structures on the chromium layer, the method being characterised in that the protective layer is formed from chromium, in that the further metallic layer is formed from tungsten, and in that the etching of the tungsten layer is carried out using an etching agent containing oxygenated, fluorinated plasma ions.

By using a chromium mask rather than a photoresist mask and an etching agent that is highly selective to both the etch stop and mask layers the definition of the tungsten structures is greatly improved over known metallic structures. The structures can be formed with an aspect ratio less than or equal to unity. This allows more compact circuits to be produced.

The present invention overcomes the disadvantages and limitations of the prior art by providing an improved method of forming tungsten structures on a semiconductor device. The tungsten structures are deposited over a protective chromium layer that is sputtered onto the surface of the semiconductor. The tungsten layer is deposited using low pressure chemical vapor deposition techniques which provides a uniform layer of tungsten that is capable of filling deep holes and trenches in a uniform manner without producing shadowing effects. This deposition technique is described in VLSI Technology,, International Student Edition, Ed. S.M Sze, McGraw-Hill 1983 pp 360-361. A second chromium layer is deposited over the surface of the tungsten layer and etched using a photoresist mask using a mixture of oxygen and chlorine ions in a reactive ion etcher. The second chromium layer is very thin compared to the photoresist layer so that the second chromium layer is etched very easily to form the mask with minimal linewidth loss. The mixture of oxygen and chlorine ions have a high selectivity to tungsten so that there is minimal degradation of the tungsten layer during etching of the second chromium layer. The tungsten layer is then etched with a mixture of carbon tetrafluoride and oxygen ions in a reactive ion etcher which comprises an extremely anisotropic etching process to maintain the integrity of the tungsten structure. Since the carbon tetrafluoride and oxygen ions have a high selectivity to chromium, there is minimal erosion of the hard chromium mask and minimal linewidth degredation of the tungsten structure during etching. Additionally, the first chromium layer protects underlying layers, such as semiconductor layers, during the process of etching the tungsten. A mixture of oxygen and chlorine ions is then used to etch the chromium mask and exposed portions of the first chromium layer using a reactive ion etcher. Since the oxygen and chlorine ions are highly selective to the underlying layers of the semiconductor and the tungsten, the tungsten and underlying layers of the semiconductor are not damaged during the chromium etching process.

The advantages of the present invention are that the tungsten structures have a high melting temperature, are harder and more dense and are not nearly as susceptible to electromigration problems as aluminum. Hence, the inherent limitations on minimal size of tungsten structures is much smaller than the inherent size limitations of aluminum. Consequently, much greater circuit densities can be achieved using tungsten structures.

Additionally, tungsten hexafluoride comprises the by-product of the etching process using carbon tetrafluoride and oxygen ions. Since tungsten hexafluoride does not have a strong affinity for water, the corrosion problems inherent with the use of chlorine atoms in the process of etching aluminum do not exist.

Moreover, the low pressure chemical vapor deposition process provides a conformal fill of tungsten over a semiconductor surface having a non-uniform topology. This eliminates the need for dogbones in the circuit and further increases the circuit density that can be achieved using the present invention. Additionally, the bottom chrome layer allows for long overetches without damaging either the underlying semiconductor layer or the tungsten structures since reactive ion etching techniques are used which do not cause undercutting. Hence, the integrity of the circuit can be maintained while long overetches are being employed to remove stringers.

### Brief Description of the Drawings

Figure 1 is a schematic illustration of an underlying semiconductor layer.

Figure 2 is a schematic illustration of an underlying semiconductor layer with a chromium layer deposited on its surface.

Figure 3 is a schematic illustration of a semiconductor layer, a chromium layer and a tungsten layer.

Figure 4 is a schematic illustration of a semiconductor, a first chromium layer, a tungsten layer and a second chromium layer.

Figure 5 is a schematic illustration of a semiconductor layer, a first chromium layer, a tungsten layer, a second chromium layer and a photoresist layer.

Figure 6 is a schematic illustration of the device of Figure 5 with the photoresist layer etched in a predetermined pattern.

Figure 7 is a schematic illustration of the device of Figure 6 with the second chromium layer etched in accordance with the photoresist layer.

Figure 8 is a schematic illustration of the device of Figure 7 with the photoresist layer removed and the tungsten layer etched in accordance with the chromium mask.

Figure 9 is a schematic illustration of the semiconductor device produced in accordance with the present invention.

Figure 10 is a schematic flow diagram of the process employed in accordance with the present invention.

Figure 11 is a plot of time verses layer reflectance to illustrate the etching process of the present invention.

Figure 12 is a plot of the line resistance of a conductor formed in accordance with the present invention versus etching time.

### Detailed Description of the Present Invention

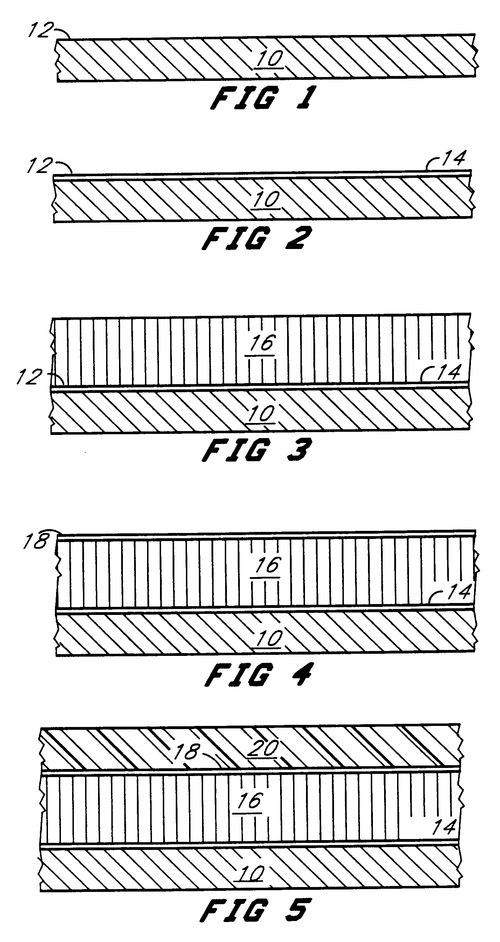

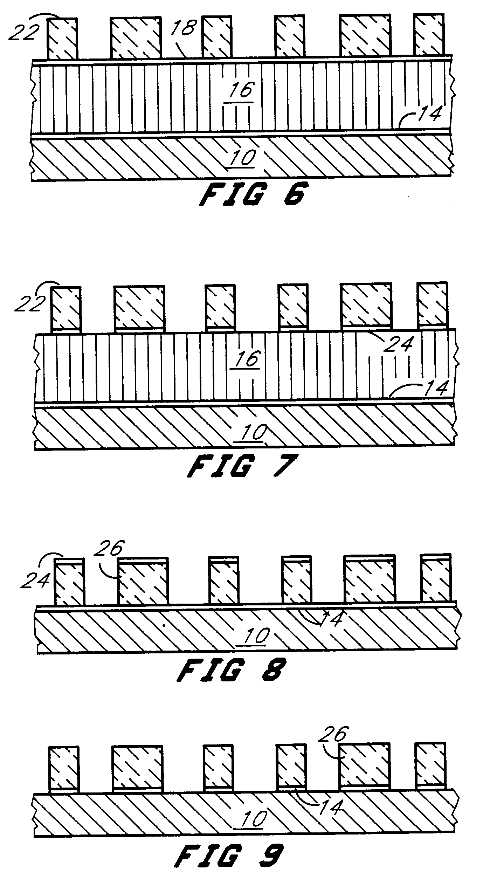

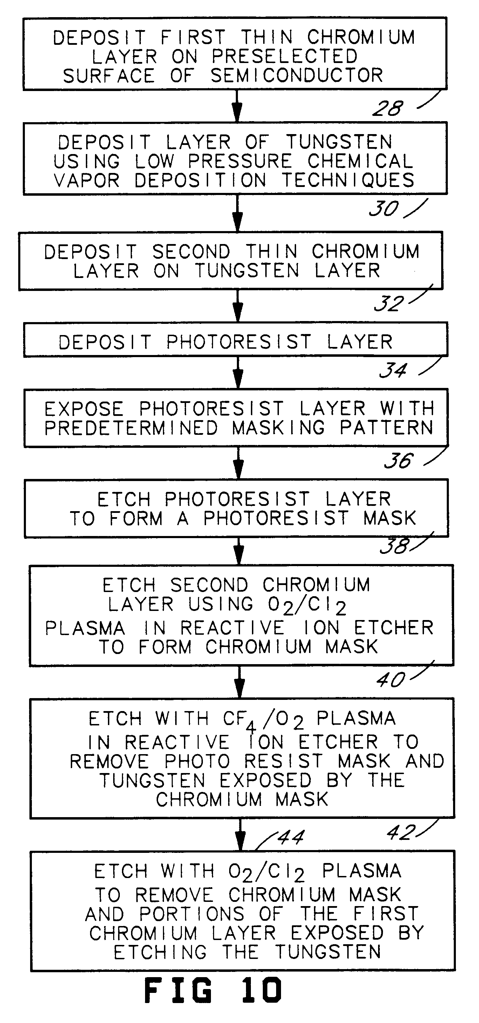

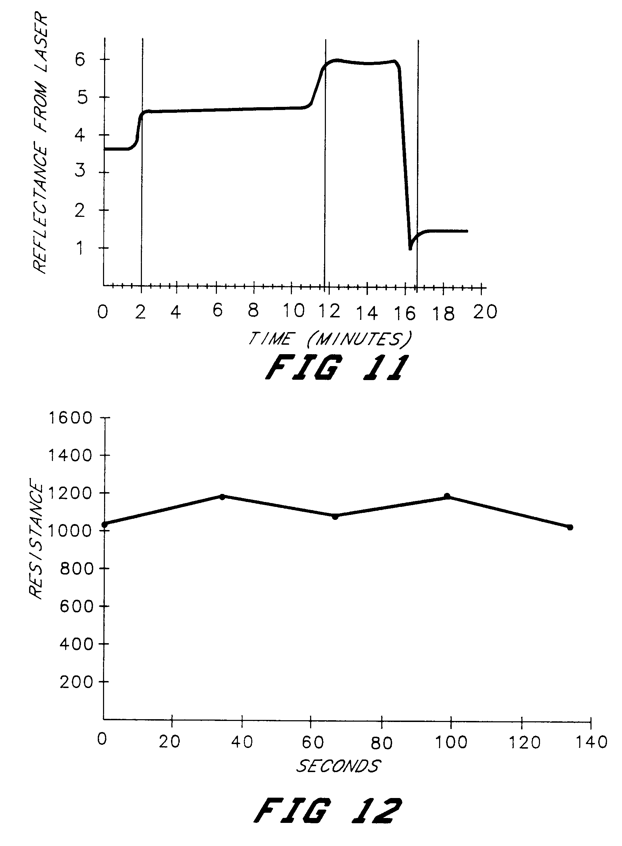

Figure 1 discloses a schematic illustration of a semiconductor layer having an upper surface 12 which may be comprised of a series of structures forming a non-uniform topology, but which is schematically shown as a flat surface 12 for the purposes of illustration.

Figure 2 comprises a schematic illustration of the semiconductor layer 10 and a chromium layer 14 that is deposited on the surface 12 of the semiconductor layer 10. The chromium layer can be deposited using any desired method of depositing chromium including sputtering or other physical vapor deposition. The chromium layer 14 provides a protective layer for semiconductor layer 10. Chromium layer 14 is typically in the range of 30 to 60nm 300 to 600 angstroms (1 angstrom = 10⁻¹⁰m.) thick.

Figure 3 is a schematic drawing illustrating the tungsten layer 16 which is deposited on the surface of a chromium layer 14 using chemical vapor deposition techniques. The deposition occurs through hydrogen reduction of tungsten hexafluoride at temperatures between 300 and 400 °C, depending primarily on the deposition rate desired. Film thicknesses of the tungsten layer 16 range from 300nm (3,000 angstroms) to more than 2µm (20,000 angstroms). The chemical vapor deposition process used to deposit the tungsten layer 16 provides a uniform layer of tungsten which fills any deep holes or trenches that have been formed on the upper surface 12 of semiconductor 10 and the upper surface of chromium layer 14.

Figure 4 schematically illustrates the structure of Figure 3 with a second chromium layer 18 deposited on the upper surface of tungsten layer 16. Again, the chromium layer 18 can be deposited using any conventional deposition process desired. Since the second chromium layer 18 will function as a mask after etching and has a high selectivity to the carbon tetrafluoride oxygen plasma mixture, it can be quite thin, i.e., on the order of 20-60nm (200-600 angstoms).

Figure 5 schematically illustrates the device of Figure 4 with an additional photoresist layer 20 deposited on the upper surface of the second chromium layer 18. Any desirable photoresist process can be employed including a standard photoresist or a two layer resist process. The PMMA two layer process typically used is more completely disclosed in Abraham, H., Bartlett, K., Hillis, G., Stoltz, M., Wilson, M., Hewlett-Packard Journal pp. 34-37, August, 1983, and is particularly useful for metal levels which tend to be both highly reflective and non-planar.

Figure 6 illustrates the manner in which the photoresist layer 20 is etched to form a mask for etching the second chromium layer 18. In order to etch the photoresist layer 20, the photoresist layer 20 must be exposed with a light source. Reflections from underlying layers can degrade the process of exposure to reduce the fidelity of the process. The chromium layer 18 functions to reduce the overall reflectance that otherwise would occur from the tungsten layer 16 by 35% at 436 nanometers using a 40nm (400 angstrom) chrome film over a 500nm (5,000 angstrom) tungsten layer deposited using LPCVD techniques. The reflected light intensity from the structure illustrated in Figure 5 is less than one third that of bare aluminum. Hence, the structures of the photo resist mask 22 illustrated in Figure 6 have a highly uniform structure.

Figure 7 illustrates the manner in which the chromium layer 18 (Figure 6) is etched using a photoresist mask 22 to form chromium mask 24 corresponding to the photoresist mask 22. Again, the underlying structure comprising the tungsten layer 16, first chromium layer 14 and semiconductor layer 10 remain as illustrated in Figure 6. Etching of the chromium layer 18 is performed by an Applied Materials AME8130 Reactive Ion Etcher available from Applied Materials, Inc. located in Santa Clara, CA and is controlled by a Hewlett-Packard 9836 computer available from Hewlett-Packard Company, Palo Alto, CA. The computer monitors the status of the etcher through an RS-232 link and the output of a laser reflectometer is fed into an HP-IB digital voltmeter so that the computer can monitor the progress of the etch as it proceeds. The computer utilizes predetermined endpoint criteria to determine the end of the etching process, as illustrated in Figure 11 and as described below. A mixture of oxygen and chlorine ions forming a plasma in the reactive ion etcher is used to etch the chromium layer 18 which replicates the photoresist mask 22 with high fidelity. Although the selectivity of the oxygen/chlorine plasma to the photoresist (PMMA) is unfavorable (1:2, CR:PMMA), the linewidth loss of the chromium mask 24 is quite small (<0.1 micrometers total), since the second chromium layer is very thin, i.e., on the order of 500 angstroms or less. The photoresist mask 22, on the other hand, normally ranges between 1.3 and 1.4 micrometers. Additionally, the anisotropic nature of etching with a reactive ion etcher reduces the amount of linewidth loss. The oxygen/chlorine plasma is highly selective to tungsten so that the process of etching the chromium mask 24 can proceed with long overetching, without damaging tungsten layer 16.

Figure 8 schematically illustrates the manner in which tungsten layer 16 (Figure 7) is etched to form tungsten structures 26. A carbon tetrafluoride/oxygen plasma is used in the AME8130 reactive ion etcher to etch the tungsten layer 16 (Figure 7) and remove portions of the tungsten that do not lie beneath the chromium mask 24, as illustrated in Figure 8, to form tungsten structures 26. Since the chromium mask 24 has a very high selectivity to chromium , i.e., greater than 50:1, very little line width loss is produced by erosion of chromium mask 24. Additionally, first chromium layer 14 functions as a protective layer for semiconductor layer 10 so that the process of etching the tungsten to form tungsten structure 26 can proceed with a long overetch and not damage the semiconductor layer 10. This is advantageous in that stringers and other undesirable structures can be removed by overetching. Again, the anisotropic nature of the reactive ion etcher prevents undercutting of the tungsten structures 26 so that a high degree of integrity and structural uniformity is produced even though long overetches are employed in this process. Additionally, the photoresist mask 22 is inherently removed during the tungsten etching process so that the structure illustrated in Figure 8 remains after the process of etching the tungsten is completed.

Figure 9 illustrates the manner in which the chromium mask 24 and chromium layer 14 are etched to leave the tungsten structures 26, as illustrated in Figure 9. Again, an oxygen/chlorine plasma is used to remove the chromium mask 24 and exposed portions of chromium layer 14. The oxygen/chlorine plasma is highly selective to the tungsten structures 26 and semiconductor layer 10, which can comprise silicon dioxide, titanium disilicide, silicon or aluminum so that no damage occurs to semiconductor layer 10. The result of the etching process is a series of tungsten structures 26 that are disposed on chromium pads 14, which are in turn disposed on semiconductor layer 10. The tungsten structures have a high degree of uniformity and structural integrity and long overetches have been used to eliminate stringers or other undesirable structures.

Figure 10 is a schematic illustration of the various steps described in forming the structures illustrated in Figures 1-9. As illustrated in Figure 10, a thin layer of chromium 14 is deposited on a preselected surface 12 of semiconductor 10, as disclosed in step 28. As disclosed in step 30, the layer of tungsten 16 is deposited using low pressure chemical vapor deposition techniques (LPCVD) to provide a uniform layer of tungsten over the upper surface of chromium layer 14. As disclosed at step 32, a second thin layer of chromium 18 is deposited over the tungsten layer 16 using conventional sputtering techniques. As disclosed at step 34, a photoresist layer 20 is deposited over the second chromium layer 18. The photoresist layer 20 is then exposed with a predetermined light pattern and etched to form a photoresist mask 22, as illustrated in steps 36 and 38. The second chromium layer 18 is then etched using an oxygen/chlorine plasma in a reactive ion etcher to form the chromium mask 24. A carbon tetrafluoride/oxygen plasma is then used to etch the tungsten layer 16 to form tungsten structures 26. Since the selectivity of the photoresist mask 22 to the carbon tetrafluoride/oxygen plasma is not large (1:1) all of the photoresist mask 22 is removed during the etching process for tungsten thicknesses greater than approximately 500nm (5,000 angstroms). The chromium mask and portions of the first chromium layer exposed during the etching of the tungsten are then removed using an etching plasma comprising oxygen and chlorine ions in a reactive ion etcher.

Figure 11 is a plot of laser reflectance versus the etching time for the etching processes illustrated in Figures 7-10. As disclosed above, a laser reflectometer is used to determine the reflectance of the semiconductor during the etching processes. Since the reflectance of the surface of the semiconductor changes as different layers are etched, a good indication can be obtained as to the stage of the etching process from the reflectance. This information is fed to the computer to determine endpoint criteria and control the reactive ion etcher to stop the etching process. As illustrated in Figure 11, the etching process for removing the second chromium layer 18 to form chromium mask 24 occurs at two minutes with sufficient overetch as illustrated in Figure 11. The tungsten etch then proceeds to approximately 14 minutes with sufficient overetch to remove stringers, as also illustrated by the plot line of Figure 11. The etch of the chromium protective layer 14 then proceeds to almost 19 minutes where a large change in reflectance occurs indicating that the chromium layer 14 has been removed.

Figure 12 is a plot of line resistance versus seconds of etching the tungsten layer to achieve a overetch. As illustrated by the plot of Figure 12, there is a minimal increase in the resistance of the tungsten structures due to linewidth loss, or undercutting, even though overetches of 100% or more are employed. The data indicates that a 5% increase in resistance for a 0.9µm wide line is produced for more than a 100% overetch. The ability to overetch by this amount without causing harm to the tungsten structure is a significant advantage of the present invention.

Hence, the present invention provides a method of forming tungsten structures in a semiconductor device which allows for a high degree of uniformity and long overetches without degrading the integrity of the resulting tungsten structures or degrading underlying semiconductor layers. High aspect ratio tungsten conductors can be formed using the method of the present invention which have a significant advantage over similar aluminum structures in that they are not susceptible to electron migration problems or corrosion because of the etching plasmas used in the process. Additionally, the use of low pressure chemical vapor deposition techniques to deposit the tungsten eliminates the need for dogbones which further increases the circuit density achievable in the present invention. The anisotropic nature of the plasma etching techniques allows for long overetches to remove stringers and other undesirable structures without causing undercutting or degrading the high aspect ratio tungsten structures. The high selectivity of the carbon tetrafluoride/oxygen plasma to chromium results in minimal linewidth loss and protection of the underlying semiconductor layers.

The foregoing description of the invention has been presented for purposes of illustration and description. It is not intended to be exhaustive. For example, the present invention can be patterned in submicron metal lines with aspect ratios of up to 1. The present invention can also be integrated into a three level metallization process with two levels of two micrometer pitch and fully external contacts on all three levels. The embodiment was chosen and described in order to best explain the principles of the invention and its practical application to thereby enable others skilled in the art to best utilize the invention in various embodiments and various modifications as are suited to the particular use contemplated.

## Claims

1. A method of forming metallic structures on a semiconductor device surface (12) comprising the steps of forming a chromium layer (14) over at least part of the surface, forming a further metallic layer (16) on the chromium layer, forming a patterned protective layer (18) over the further metallic layer, and etching the further metallic layer through the protective layer to form metallic structures on the chromium layer, the method being characterised in that the protective layer is formed from chromium, in that the further metallic layer is formed from tungsten, and in that the etching of the tungsten layer is carried out using an etching agent containing oxygenated, fluorinated plasma ions.

2. A method according to claim 1, wherein said etching agent is a carbon tetrafluoride/oxygen plasma mixture, and etching is carried out using a reactive ion etcher.

3. A method according to any preceding claim, wherein the first chromium layer (14) functions as an etch stop protective layer during etching of the tungsten layer (16).

4. A method according to any preceding claim, wherein the protective chromium layer (18) is selectively etched using a second etching agent having a high selectivity to tungsten.

5. A method according to claim 4, wherein said second etching agent contains chlorinated plasma ions.

6. A method according to claim 5, wherein said second etching agent is an oxygen/chlorine plasma mixture, and etching is carried out using a reactive ion etcher.

7. A method according to any of claims 4 to 6, wherein the protective chromium layer (18) is selectively masked using a photoresist (22) prior to etching.

8. A method according to any preceding claim, wherein the tungsten layer (16) is formed by low pressure chemical vapour deposition.

9. A method according to any preceding claim, in which the first chromium layer (14) is formed by vacuum sputtering.

## Patentansprüche

1. Verfahren zum Bilden metallischer Strukturen auf der Oberfläche (12) einer Halbleitervorrichtung mit den Schritten:
Bilden einer Chromschicht (14) auf mindestens einem Teil der Oberfläche, Bilden einer weiteren Metallschicht (16) auf der Chromschicht, Bilden einer gemusterten Schutzschicht (18) auf der weiteren Metallschicht und Ätzen der weiteren Metallschicht durch die Schutzschicht zum Formen metallischer Strukturen auf der Chromschicht, dadurch **gekennzeichnet**, daß die Schutzschicht aus Chrom gebildet ist, daß die weitere Metallschicht aus Wolfram gebildet ist und daß das Ätzen der Wolframschicht unter Verwendung eines Ätzmittels erfolgt, welches mit Sauerstoff und Fluor versetzte Plasmaionen enthält.

2. Verfahren nach Anspruch 1, bei dem das Ätzmittel ein Kohlenstoff-Tetrafluorid/Sauerstoff-Plasmagemisch ist, und daß das Ätzen unter Verwendung eines reaktiven Ionen-Ätzers erfolgt.

3. Verfahren nach einem der vorangehenden Ansprüche, bei dem die erste Chromschicht (14) als Ätzstop-Schutzschicht beim Ätzen der Wolframschicht (16) fungiert.

4. Verfahren nach einem der vorangehenden Ansprüche, bei dem die schützende Chromschicht (18) wahlweise unter Verwendung eines zweiten Ätzmittels mit einer hohen Selektivität bezüglich Wolfram geätzt wird.

5. Verfahren nach Anspruch 4, bei dem das zweite Ätzmittel chlorinierte Plasmaionen enthält.

6. Verfahren nach Anspruch 5, bei dem das zweite Ätzmittel ein Sauerstoff/Chlor-Plasmagemisch ist, und daß das Ätzen unter Verwendung eines reaktiven Ionen-Ätzers durchgeführt wird.

7. Verfahren nach einem der Ansprüche 4-6, bei dem die schützende Chromschicht (18) wahlweise unter Verwendung eines Photoresist (22) vor dem Ätzen maskiert wird.

8. Verfahren nach einem der vorangehenden Ansprüche, bei dem die Wolframschicht (16) durch chemisches Niederdruck-Aufdampfen abgelagert wird.

9. Verfahren nach einem der vorangehenden Ansprüche, bei dem die erste Chromschicht (14) durch Vakuum-Sputtern gebildet wird.

## Revendications

1. Procédé de formation de structures métalliques sur une surface de dispositif à semiconducteur (12), comprenant les étapes de formation d'une couche de chrome (14) sur au moins une partie de la surface, de formation d'une autre couche métallique (16) sur la couche de chrome, de formation d'une couche de protection conformée (18) sur l'autre couche métallique et de gravure de l'autre couche métallique au travers de la couche de protection afin de former des structures métalliques sur la couche de chrome, le procédé étant caractérisé en ce que la couche de protection est réalisée à partir de chrome, en ce que l'autre couche métallique est réalisée à partir de tungstène et en ce que la gravure de la couche de tungstène est mise en oeuvre en utilisant un agent de gravure contenant des ions de plasma oxygénés et fluorés.

2. Procédé selon la revendication 1, dans lequel ledit agent de gravure est un mélange de plasma d'oxygène/tétrafluorure de carbone et dans lequel la gravure est mise en oeuvre en utilisant un dispositif de gravure ionique réactive.

3. Procédé selon l'une quelconque des revendications précédentes, dans lequel la première couche de chrome (14) constitue une couche de protection d'arrêt de gravure lors de la gravure de la couche de tungstène (16).

4. Procédé selon l'une quelconque des revendications précédentes, dans lequel la couche de chrome de protection (18) est gravée de façon sélective en utilisant un second agent de gravure présentant une sélectivité élevée par rapport au tungstène.

5. Procédé selon la revendication 4, dans lequel ledit second agent de gravure contient des ions de plasma chlorurés.

6. Procédé selon la revendication 5, dans lequel ledit second agent de gravure est un mélange de plasma d'oxygène/chlore et dans lequel une gravure est mise en oeuvre en utilisant un dispositif de gravure ionique réactive.

7. Procédé selon l'une quelconque des revendications 4 à 6, dans lequel la couche de chrome de protection (18) est masquée de façon sélective en utilisant une photorésine (22) avant la gravure.

8. Procédé selon l'une quelconque des revendications précédentes, dans lequel la couche de tungstène (16) est formée au moyen d'un dépôt chimique en phase vapeur basse pression.

9. Procédé selon l'une quelconque des revendications précédentes, dans lequel la première couche de chrome (14) est formée par pulvérisation sous vide.
